# EUROPÄISCHE PATENTSCHRIFT

(11) **EP 1 965 494 B1**
(45) Veröffentlichungstag und Bekanntmachung des Hinweises auf die Patenterteilung: **09.09.2009**
(21) Anmeldenummer: 08003873.0
(22) Anmeldetag: 03.03.2008
(51) Int. Cl.: H03K 17/955, H03K 17/96, A47K 13/30

(54) **Verfahren zum Detektieren einer WC-Benutzung und WC-Sitz-Anordnung**
Method for detecting use of a WC and WC seat assembly
Procédé de détection d'une utilisation de WC et agencement de siège de WC

(30) Priorität: 02.03.2007 DE 102007010788
(43) Veröffentlichungstag der Anmeldung: 03.09.2008
(73) Patentinhaber: Pagette GmbH, 46242 Bottrop (DE)
(72) Erfinder: Seelig, Torsten, 46348 Reasfeld (DE); Dickfeld, Erich, 01979 Lauchhammer (DE); Willers, Carsten, 48683 Ahaus (DE)
(74) Vertreter: Fechner, Benjamin

(56) Entgegenhaltungen:
- DE-U1-202004 012 063
- JP-A- 2004 201 200
- JP-A- 2006 070 566
- JP-A- 2006 200 150

## Beschreibung

Die Erfindung betrifft ein Verfahren zum Detektieren einer WC-Benutzung. Die Erfindung ist ferner gerichtet auf eine WC-Sitz-Anordnung.

In Toilettenanlagen besteht zunehmend die Notwendigkeit, bei der Benutzung entstehende Geruchsbelästigungen einzudämmen. Dies gilt insbesondere auch für öffentliche Anlagen.

Aus dem Stand der Technik sind verschiedene Lösungsansätze zur Geruchsreduzierung bekannt. Beispielsweise werden WC-Sitze mit Absaugsystemen ausgebildet, die in unmittelbarer Umgebung zu dem WC oder in dem WC-Sitz selbst angeordnet sind. Derartige Absaugsysteme sind jedoch aufwendig und verändern in aller Regel den Gesamteindruck der Toilette. Hinzu kommt, dass die Absaugsysteme schwer zugänglich sind, was die Instandhaltung erschwert, und durch offene Baugruppen der Gefahr von Vandalismus ausgesetzt sind.

Die Aktivierung bekannter Absaugvorrichtungen erfolgt häufig durch den Benutzer selbst. Hierbei werden die Absaugvorrichtungen "von Hand" ausgeschaltet. Alternativ werden Systeme eingesetzt, die die Anwesenheit einer Person erfassen und bei Erfassung den Absaugvorgang einleiten. Hierzu gehören beispielsweise Infrarotsensorsysteme oder Ultraschallsensorsysteme. Derartige Verfahren können jedoch nicht zwischen dem bloßen Betreten einer Toilettenanlage (bei der keine Absaugung erforderlich ist) und der Benutzung der Toilette unterscheiden. Die Folge sind Fehlauslösungen, die unnötige Energie und Wasser verschwenden. Auch bei derartigen Anlagen besteht die Gefahr einer mutwilligen Zerstörung.

Der Erfindung liegt die **Aufgabe** zugrunde, Toilettenanlagen so weiterzuentwickeln, dass eine möglichst zuverlässige Detektion von WC-Benutzern möglich ist und gleichzeitig eine unerwünschte Manipulation der Anlage erschwert wird.

Zur **Lösung** dieser Aufgabe schlägt die Erfindung ein Verfahren zum Detektieren einer WC-Benutzung vor, bei dem
- über eine in einem WC-Sitz integrierte kapazitive Sensoreinheit die Änderung der Kapazität bei Benutzung des WC's erfasst wird,
- bei Änderung der Kapazität von der kapazitiven Sensoreinheit ein ebenfalls in den WC-Sitz integrierter Funksender angesteuert wird,
- der Funksender ein Funksignal abgibt, das von einer entfernt von dem WC-Sitz angeordneten Empfangseinheit erfassbar ist, und wobei
- ein von der Empfangseinheit angesteuerter Aktor eine Aktion durchführt.

Die Erfindung schlägt einen vollständig neuen Weg der Geruchsreduzierung ein. Vorzugsweise durchsetzt die kapazitive Sensoreinheit die Brille des WC-Sitzes mit einem elektrischen Feld. Das elektrische Feld ändert sich, sobald sich ein Benutzer auf die Brille setzt. Bei Änderung des elektrischen Feldes wird ein Funksender angesteuert, der ein Funksignal an eine Empfangseinheit abgibt, die bei Erfassung des Signals mindestens einen Aktor ansteuert. Bei der von dem Aktor durchgeführten Aktion handelt es sich vorzugsweise um eine Aktion zur Reduzierung der Geruchsbelästigung. Hierbei kann es sich z.B. um die Aktivierung eines Ventilators, die Auslösung von Zwischenspülvorgängen, oder das Öffnen eines Fensters handeln. Es wird jedoch darauf hingewiesen, dass im Rahmen der Erfindung weitere Aktionen möglich sind, wie z.B. die Beheizung der Toilettenanlage oder Teilen davon, das Abspielen von Musik und vieles mehr.

Alle Bauteile sind erfindungsgemäß in dem WC-Sitz integriert. Dadurch sind sie für den Benutzer unzugänglich und geschützt vor einer ungewollten Manipulation.

Die Empfangseinheit wird man in aller Regel in der Nähe des Senders anordnen. Aufgrund der geringen Entfernung ist der erforderliche Energieaufwand sehr gering. Eine lange Lebensdauer ist die Folge. Als Energieversorgung kommen beispielsweise eine Batterie oder ein Akkumulator in Betracht, wobei eine Batterie (wie auch die übrigen Baugruppen) vorteilhaft in dem Sitz vergossen werden können. Dadurch ist der WC-Sitz vor einer Manupulation vollends geschützt.

Mit der Erfindung ist es möglich, bestehende WC-Sitze durch die erfindungsgemäßen Sitze zu ersetzen, ohne dass eine Anpassung der Toilette erforderlich ist. Eine Installation kann mithin auch im Privatbereich ohne zusätzlichen Aufwand durchgeführt werden.

Die Erfindung findet beispielsweise auch in Bereichen Einsatz, wo neben dem WC eine Dusch- oder Badeeinrichtung vorgesehen ist. Bei deren Benutzung kommt es zu einem Anstieg der Feuchtigkeit in diesem Raum. Feuchtigkeit kann zu einer Änderung der Kapazität führen. Diese Änderung erfolgt jedoch nur langsam. Vorzugsweise wird der Funksender daher erst dann angesteuert, wenn eine sprunghafte Änderung der Kapazität erfasst wird, wie sie auftritt, wenn eine Person sich auf die Brille setzt.

Es kann ferner vorteilhafterweise die Zeitspanne einstellbar sein, innerhalb derer eine Änderung der Kapazität erfolgen muss, um den Funksender anzusteuern. Die Zeitspanne wird man vor Einbau der Sensoreinheit festlegen. Zusätzlich kann vorgesehen sein, dass die relative Höhe der Änderung der Kapazität einstellbar ist, ab der der Funksender zur Auslösung der Aktion angesteuert wird.

Die Aufgabe wird ferner durch eine WC-Sitz-Anordnung gelöst, die folgende Merkmale aufweist:
- einen WC-Sitz,
- eine kapazitive Sensoreinheit zur Erfassung der Änderung der Kapazität,
- einen Funksender zur Abgabe eines Impulses an eine Empfangseinheit,
- wobei die Sensoreinheit bei Änderung der Kapazität den Funksender ansteuert, und
- eine Energieversorgung zur Versorgung der Sensoreinheit und des Funksenders mit Energie,
- wobei die Sensoreinheit, der Funksender und die Energieversorgung in den WC-Sitz integriert sind.

Häufig weisen WC-Sitze an der Unterseite der Brille Puffer auf, die auf dem WC-Becken aufliegen und die Brille dämpfen. Eine vorteilhafte Ausführungsform der Erfindung ist dadurch gekennzeichnet, dass der WC-Sitz mindestens einen Puffer aufweist, und dass die Sensoreinheit, der Funksender und die Energieversorgung in einer Ausnehmung des WC-Sitzes angeordnet sind, die durch den Puffer verschlossen und/oder zugänglich ist. Der Puffer kann mit der Brille verklebt oder lediglich in die Brille (lösbar) eingesetzt sein. Bei der Herstellung werden vorzugsweise die einzelnen Elemente zunächst in die Ausnehmung eingesetzt und anschließend der Puffer in die Brille eingesetzt und verklebt. Die Herstellung eines derartigen erfindungsgemäßen WC-Sitzes ist einfach, kostengünstig und weist neben den vorstehend genannten Vorteilen insbesondere eine hohe Sicherheit gegen Vandalismus auf.

Als konstruktiv besonders vorteilhaft hat es sich erwiesen, wenn die maximale Höhe der Sensoreinheit, des Funksenders und der Energieversorgung kleiner ist als der Querschnitt des WC-Sitzes im Bereich von deren Aufnahme. Alle Bauteile sind also vollständig im WC-Sitz aufgenommen und damit gut geschützt gegen äußere Einwirkung. Im Rahmen der Erfindung liegt es, wenn die Bauteile teilweise übereinandergestapelt angeordnet sind. Zweckmäßig erstreckt sich das Material des WC-Sitzes im Bereich der Aufnahme der Bauteile über die Bauteile hinaus.

Im folgende wird die Erfindung anhand eines bevorzugten Ausführungsbeispiels im Zusammenhang mit der anhängenden Zeichnung näher erläutert. Die **Zeichnung** zeigt in der einzigen
Figur in schematischer Darstellung eine Schnittansicht durch die Brille einer erfindungsgemäßen WC-Sitz-Anordnung.

In der Brille 1 ist erfindungsgemäß eine Ausnehmung 2 ausgebildet. In der Ausnehmung 2 sind eine Sensoreinheit, die eine Sensorelektronik 3 und eine Sensorfläche 4 umfasst, ein Funksender 5 und eine Energieversorgung 6 angeordnet. Auf der Unterseite der Brille ist ein Puffer 7 zur Auflage auf einem (nicht gezeigten) WC-Becken angeordnet, der die Ausnehmung 2 zumindest teilweise verschließt. Vorzugsweise sind die Ausnehmung 2 und die darin enthaltenen Komponenten 3 - 6 über den Puffer zugänglich.

Von der Sensorfläche 4 gehen die lediglich angedeuteten Feldlinien 8 ab. Sobald sich eine Person auf die Brille 1 setzt, ändern sich die Feldlinien 8. Diese Änderung wird von der Sensorelektronik 3 erfasst, woraufhin die Sensorelektronik 3 den Funksender 5 ansteuert, der ein (schematisch angedeutetes) Funksignal 9 aussendet, das von einer (nicht gezeigten) Empfangseinheit empfangen wird. Die Empfangseinheit in einigen Abstand zu dem Funksender 5, beispielsweise in einigen Metern, angeordnet und steuert einen Aktor an, der beispielsweise als Ventilator ausgebildet sein kann.

### Bezugszeichenliste

- 1: Brille
- 2: Ausnehmung
- 3: Sensorelektronik
- 4: Sensorfläche
- 5: Funksender
- 6: Energieversorgung
- 7: Puffer
- 8: Feldlinien
- 9: Funksignal

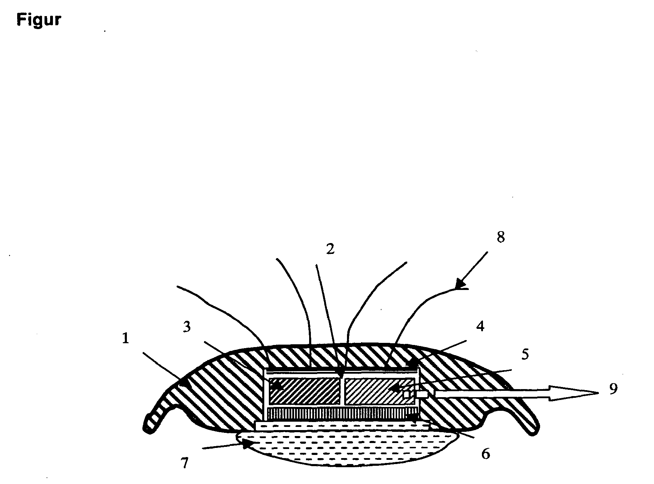

## Patentansprüche

1. Verfahren zum Detektieren einer WC-Benutzung, wobei
- über eine in einem WC-Sitz integrierte kapazitive Sensoreinheit die Änderung der Kapazität bei Benutzung des WC's erfasst wird,
- bei Änderung der Kapazität von der kapazitiven Sensoreinheit ein ebenfalls in den WC-Sitz integrierter Funksender angesteuert wird,
- der Funksender ein Funksignal abgibt, das von einer entfernt von dem WC-Sitz angeordneten Empfangseinheit erfassbar ist, und wobei
- ein von der Empfangseinheit angesteuerter Aktor eine Aktion durchführt.

2. verfahren nach Anspruch 1, **dadurch gekennzeichnet, dass** es sich bei der Aktion um eine Aktion zur Reduzierung der Geruchsbelästigung handelt.

3. Verfahren nach Anspruch 1 oder 2, **dadurch gekennzeichnet, dass** der Funksender erst angesteuert wird, wenn eine sprunghafte Änderung der Kapazität erfasst worden ist.

4. Verfahren nach einem der Ansprüche 1 - 3, **dadurch gekennzeichnet, dass** die Zeitspanne einstellbar ist, innerhalb derer eine Änderung der Kapazität erfolgen muss, um den Funksender anzusteuern.

5. WC-Sitz-Anordnung, mit
- einem WC-Sitz,
- einer kapazitiven Sensoreinheit (3, 4) zur Erfassung der Änderung der Kapazität,
- einem Funksender (5) zur Abgabe eines Impulses an eine Empfangseinheit,
- wobei die Sensoreinheit (3, 4) bei Änderung der Kapazität den Funksender (5) ansteuert, und mit
- einer Energieversorgung (6) zur Versorgung der Sensoreinheit (3, 4) und des Funksenders (5) mit Energie,
- wobei die Sensoreinheit (3, 4), der Funksender (5) und die Energieversorgung (6) in den WC-Sitz integriert sind.

6. WC-Sitz-Anordnung nach Anspruch 5, **dadurch gekennzeichnet,**
- **dass** der WC-Sitz mindestens einen Puffer (7) aufweist, und
- **dass** die Sensoreinheit (3, 4), der Funksender (5) und die Energieversorgung (6) in einer Ausnehmung (2) des WC-Sitzes angeordnet sind, die durch den Puffer verschlossen und/oder zugänglich ist.

7. WC-Sitz-Anordnung nach Anspruch 5 oder 6, **dadurch gekennzeichnet, dass** die Energieversorgung (6) eine Batterie oder ein Akkumulator ist.

8. WC-Sitz-Anordnung nach einem der Ansprüche 5 bis 7, **dadurch gekennzeichnet, dass** die maximale Höhe der Sensoreinheit (3, 4), des Funksenders (5) und der Energieversorgung (6) kleiner ist als der Querschnitt des WC-Sitzes im Bereich von deren Aufnahme.

## Claims

1. A method of detecting use of a WC, wherein
- the change in capacitance on use of the WC is detected by means of a capacitive sensor unit integrated into a WC seat,
- a radio transmitter, which is also integrated into the WC seat, is activated by the capacitive sensor unit when the capacitance changes,
- the radio transmitter emits a radio signal, which is detectable by a receiving unit arranged remotely from the WC seat, and wherein
- an actuator controlled by the receiving unit performs an action.

2. A method as claimed in Claim 1, **characterised in that** the action is an action to reduce the odour pollution.

3. A method as claimed in Claim 1 or 2, **characterised in that** the radio transmitter is only activated when an abrupt change in the capacitance is detected.

4. A method as claimed in one of Claims 1 - 3, **characterised in that** the period of time within which a change in the capacitance must occur in order to activate the radio transmitter is adjustable.

5. A WC seat arrangement including
- a capacitive sensing unit (3, 4) for detecting the change in capacitance,
- a radio transmitter (5) for emitting a pulse to a receiving unit,
- wherein the sensor unit (3, 4) activates the radio transmitter (5), when the capacitance changes, and including
- an energy supply (6) for supplying the sensor unit (3, 4) and the radio transmitter (5) with energy,
- wherein the sensor unit (3, 4), the radio transmitter (5) and the energy supply (6) are integrated into the WC seat.

6. A WC seat arrangement as claimed in Claim 5, **characterised in that**
- the WC seat has at least one buffer (7), and
- that the sensor unit (3, 4), the radio transmitter (5) and the energy supply (6) are arranged in a recess (2) in the WC seat, which is closed by the buffer and/or is accessible.

7. A WC seat arrangement as claimed in Claim 5 or 6, **characterised in that** the energy supply (6) is a battery or an accumulator.

8. A WC seat arrangement as claimed in one of Claims 5 to 7, **characterised in that** the maximum height of the sensor unit (3, 4), the radio transmitter (5) and the energy supply (6) is smaller than the cross section of the WC seat in the vicinity of the recess in it.

## Revendications

1. Procédé de détection de l'utilisation d'un WC, dans lequel
- au moyen d'une unité de capteur capacitif intégrée dans un siège de WC, on détecte la variation de la capacité en cas d'utilisation du WC,
- en cas de variation de la capacité, on commande au moyen de l'unité de capteur capacitif un émetteur radio également intégré dans le siège de WC,
- l'émetteur radio émet un signal radio, qui peut être détecté par une unité de réception disposée à distance du siège de WC, et dans lequel
- un actionneur commandé par l'unité de réception exécute une action.

2. Procédé selon la revendication 1, **caractérisé en ce que** l'action est une action destinée à réduire les nuisances olfactives.

3. Procédé selon la revendication 1 ou 2, **caractérisé en ce que** l'émetteur radio n'est commandé que lorsque l'on détecte une variation brusque de la capacité.

4. Procédé selon l'une quelconque des revendications 1 à 3, **caractérisé en ce que** l'on peut régler le laps de temps à l'intérieur duquel une variation de la capacité doit se produire pour commander l'émetteur radio.

5. Agencement de siège de WC, avec
- un siège de WC,
- une unité de capteur capacitif (3, 4) destinée à détecter la variation de la capacité,
- un émetteur radio (5) destiné à envoyer une impulsion à une unité de réception,
- dans lequel l'unité de capteur (3, 4) commande l'émetteur radio (5) lors d'une variation de la capacité, et avec
- une source d'énergie (6) pour alimenter en énergie l'unité de capteur (3, 4) et l'émetteur radio (5),
- dans lequel l'unité de capteur (3, 4), l'émetteur radio (5) et la source d'énergie (6) sont intégrés dans le siège de WC.

6. Agencement de siège de WC selon la revendication 5, **caractérisé en ce que**
- le siège de WC comprend au moins un coussin (7), et
- l'unité de capteur (3, 4), l'émetteur radio (5) et la source d'énergie (6) sont disposés dans une cavité (2) du siège de WC, qui est fermée par le coussin et/ou qui est accessible.

7. Agencement de siège de WC selon la revendication 5 ou 6, **caractérisé en ce que** la source d'énergie (6) est une batterie ou un accumulateur.

8. Agencement de siège de WC selon l'une quelconque des revendications 5 à 7, **caractérisé en ce que** la hauteur maximale de l'unité de capteur (3, 4), de l'émetteur radio (5) et de la source d'énergie (6) est inférieure à la section transversale du siège de WC dans la région de leur logement.
